# EUROPEAN PATENT SPECIFICATION

(11) **EP 0 720 315 B1**
(45) Date of publication and mention of the grant of the patent: **04.08.1999**
(21) Application number: 94120923.1
(22) Date of filing: 30.12.1994
(51) Int. Cl.: H04B 14/00, H03D 3/24

(54) **Method for narrow band frequency modulation or phase modulation; transmitter and receiver for carrying out the method**
Verfahren zur schmallbandigen Frequenz- oder Phasenmodulation Sender und Empfänger zur Ausführung des Verfahrens
Procédé de modulation de fréquence ou de phase à largeur de bande réduite; émetteur et récepteur pour la mise en oeuvre de ce procédé

(43) Date of publication of application: 03.07.1996
(73) Proprietor: Al-Eidan, Abdullah A., Postal Code 43600 (KW)
(72) Inventor: Al-Eidan, Abdullah A., Postal Code 43600 (KW)
(74) Representative: Eisenführ, Speiser & Partner

(56) References cited:
- EP-A- 0 545 596
- WO-A-90/16115
- GB-A- 2 015 282

## Description

### INTRODUCTION

In recent years the VHF and the UHF bands became very congested especially with the expansion of the cellular telephones and pagers networks and the need for more channels force the manufacturers to use higher frequency bands to avoid the interference between the channels and for better frequency management, using upper UHF band will expose the users and the operators to the high frequency radiation and that may cause health problems. One of the solutions to increase the number of channels is to use a narrow band system but these systems produce a poor sound quality and a low baud rate data transmission. The present invention provides a solution to increase the number of channels by using a narrow band frequency modulation (FM) or phase modulation (PM) that can produce an excellent sound quality.

From GB-A-2 105 282 it is known a FM receiver which includes a signal conversion circuit operating to produce a first IF signal on a first intermediate frequency. The first IF signal of this known FM receiver is fed to a resonance circuit tuned to the Nth harmonic of this first intermediate frequency. The known FM receiver includes a frequency conversion stage which receives the output of the resonance circuit and provides a second IF signal which is demodulated by an FM detector.

From WO-A-90/16115 it is known an FM detection system which receives an FM input signal containing a tuned carrier separated by guard bands from side carriers. In this known system a guard band expander receives a heterodyned input signal and produces a resultant signal in which resultant guard band proportionally wider relative to the tuned carrier than the guard bands of the original FM signal. An embodiment of this known system shows a guard band expander which includes at least one harmonics generator, which acts as a frequency multiplier and generates harmonics either of the down-converted signal or of the FM signal before heterodyning. The output signal from the guard band expander of this known system is then band-pass filtered by a filter tuned to the tuned carrier frequency or its post-multiplication equivalent. Finally the filtered signal is demodulated to produce a final output signal.

From PLESSEY Semiconductors, Linear Integrated Circuit Handbook, September 1985, pages 121 - 123, it is known a staight through or single conversion IF amplifier and detector for FM radio applications. This know device uses a phase locked loop detector, with a crystal oscillator, a mixer for conversion to the IF amplifier, a PLL detector and a squelch system.

### THE OBJECTIVE OF THE INVENTION

The purpose of this invention is to use narrow band frequency or phase modulation transmitters and receivers to achieve the following:
A - increase the number of the channels.
B - improve the sound quality.
C - high signal to noise ratio.
D - increase the power of the transmitted information.

### THE SCOPE OF THE INVENTION

There are stages of frequency deviation in the FM/PM transmitters.
A - the first stage, the primary frequency deviation, which occurs in the frequency/phase modulator where the carrier frequency fluctuate or deviate in a rate according to the amplitude or the amplitude and the frequency of the modulating signal.
B - the second stage, the secondary frequency deviation which occurs in the frequency multiplier stage were the frequency deviation and the modulation index will multiply by the same factor that the carrier fequency mulitplied without causing distortion.
C - the result of the two stages of frequency deviation offers a means for obtaining practically a desired amount of carrier frequency, frequency deviation and modulation index.
D - in the FM receiver the value of the modulation index determines the quality of the sound, if the modulation index is high, which corresponds to a high frequency deviation, the frequency discriminator become more sensitive and can detect even minor frequency deviation.

The first stage of frequency deviation, the modulator, is the heart of the system were the information signal transformed into a rate of frequency deviation; the second stage of frequency deviation, the frequency multiplier, is increasing the carrier frequency. At the same time it will increase the amount of frequency deviation and this does not have any distortion in the nature of the modulation introduced by the frequency change because it has the same rate of frequency deviation of the modulator.

Therefore it is the object of the invention to modify the structure of the FM and of the PM transmitters and receivers as explained below.

This object is solved by a method for transmitting frequency modulated or phase modulated signals via a communication channel, characterized by frequency or phase modulating said signal with a pregiven small frequency deviation (modulation index 1.0 or smaller) at the transmitting side signal of the communication channel, transmitting said frequency or phase modulated signal via the communication channel, receiving said frequency or phase modulated signal at the receiving side of the communication channel and expanding the frequency deviation of the received signal, further processing the expanded frequency or phase modulated signal in any wanted manner. The frequency expansion at the receiving side of the communication channel is preferably realized by frequency multiplication.

### THE TRANSMITTER

According to the invention the modification in the transmitter will be applied in the following:
the secondary frequency deviation will be reduced by reducing the amount of frequency multiplication by using higher frequency crystals or the wave translated in the frequency spectrum by heterodyne action;
reducing the primary frequency deviation by adjusting the amplitude of the modulating signal so that the total frequency deviation of the transmitted frequency will not exceed a pregiven band width, for example ± 5 KHz,
adjusting the band pass filters to avoid the interference and cutting the noise.

In case the FM modulated signal in the transmitter shows a distortion in shape, particularly if the modulation index is low and if the modulating signals are sine waves, means have to be provided to remove this distortion in the transmitter. To do this, the quasi-steady-state method may be used, if the maximum rate of change of instantaneous frequency is small, or the curves giving magnitude and phase of the admittance Y (wi) as a function of frequency are both substantially linear over the range of instantaneous frequency involved.

### THE RECEIVER

According to the invention to receive the narrow band FM/PM signal, the structure of the conventional FM/PM receiver must be modified by adjusting the band pass filters so that the narrow band signal can be received and a frequency multiplier stage can be added.

The narrow band FM or PM signal will be received at a FM receiver which includes RF amplifier means, followed by a mixer and an IF amplifier stage. Then the IF signal is multiplied, for example by a multiplication factor of 20, and in this way a secondary frequency deviation is generated locally in the receiver, and in this way the frequency deviation which was reduced in the transmitter is compensated. By these means the new wide band signal is realized.

The new wide band signal will pass through a limiter to eliminate all amplitude variations in the signal, and after that, the signal will pass to a discriminator which converts the signal output of the limiter to an audio signal where by the frequency output is at the rate of the frequency deviation and the amplitude is proportionally to the magnitude of the frequency deviation. Finally, the signal will pass to an output stage including an audio amplifier and conventional signal processing circuits.

According to the invention a narrow band FM/PM can be implemented by transmitting a signal of a small frequency deviation (for example ± 5 KHz), and this small frequency deviation can be expanded preferably after converting this signal down to an IF signal, by additionally frequency-multiplying this IF signal. In this way the band width limitation, i.e. the frequency deviation of the transmitter and of the communication channel can be extended. The result is a high quality sound similar to the CD ROM sound quality, if the digital audio is implemented. The narrow band FM can be implemented in the medium wave band (MW-band) and in the high frequency band (HF-band), and it can be broadcasted in stereo.

To implement the narrow band FM or PM in accordance with this invention, it is very important to setup a standard to determine the channel spacing to control the total frequency deviation in the transmitter and to determine the number of frequency multiplication to the intermediate frequency in the receiver.

In conventional frequency modulation (FM) or phase modulation (PM) with small frequency deviation (i.e. with a modulation index of 1 or smaller) the output signal is comparatively small when using a conventional frequency discrimination for the demodulation. As a result, signal distortions are comparatively high. However, in many cases it is advantageous to use a frequency modulation with small modulation index M, as the frequency modulation can be realized with small power. Particularly however, the number of transmission channels in a pregiven frequency range can be increased in using FM or PM with small frequency deviation.

In accordance with the present invention, the transmission of FM or PM modulated signals can be realized with a small band channel with improved sound quality. By the invention the number of channels or a transmission with given frequency range can be increased, and simultaneously the sound quality can be improved.

In accordance with the present invention, the small band signal is received and conventionally converted in a FM receiver into the intermediate frequency (IF-signal). Then, the IF signal with its small frequency band is expanded by frequency multiplication; then a frequency discriminator at the demodulation stage receives a signal with a correspondingly larger band widths. When this expanded signal is then applied to a conventional discriminator, the discriminator works with less distortion, resulting in a high quality output signal.

The invention is now described in detail by way of an example in the following drawings which show:
- Fig. 1: a block diagram of the transmitter for FM or PM signals in accordance with the invention;
- Fig. 2: a block diagram of an alternative transmitter for FM or PM signals in accordance with the invention;
- Fig. 3: a block diagram of a receiver for FM signals in accordance with the invention;
- Fig. 4: a block diagram of a phase locked loop with frequency multiplication and down converter in accordance with the invention; and
- Fig. 5: a block diagram of a FM receiver with limiter stage before the P.L.L. frequency multiplier stage and with P.L.L. discriminator in accordance with the invention.

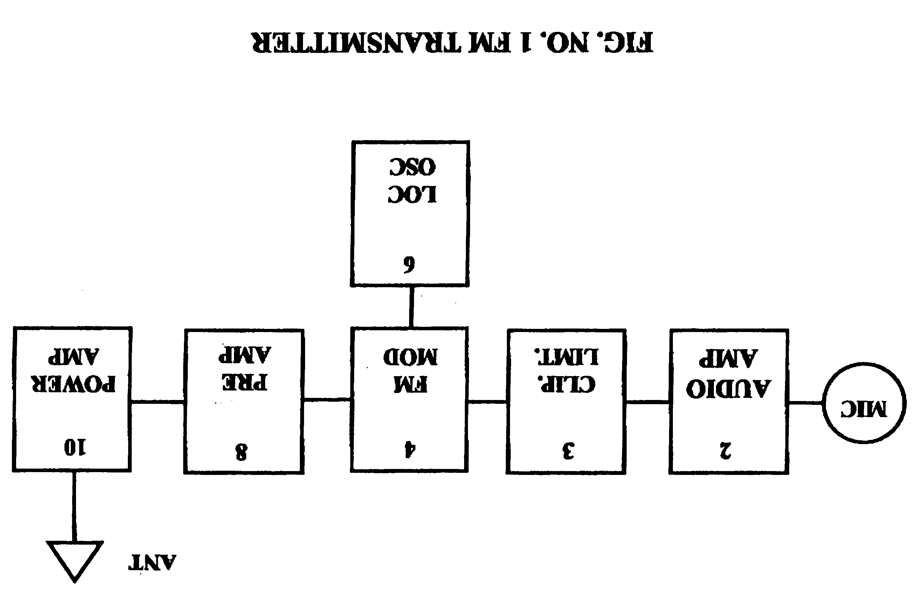

Fig. 1 shows a block diagram of the transmitter including frequency modulation. At the input the transmitter includes an audio frequency amplifier 2 which is succeeded by a frequency modulation stage 4 with local oscillator 6. Connected with this frequency modulation stage 4 is a preamplifier 8 and a power amplifier 10. A modulation index M, is selected to a small value resulting in a small frequency band for transmitting the output signal of the transmitter.

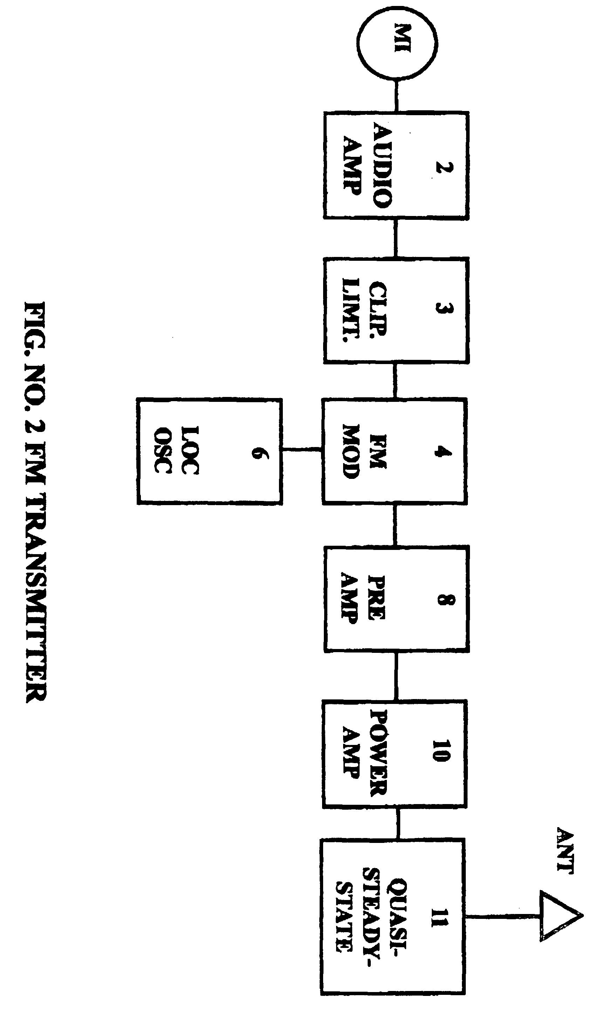

Fig. 2 shows a block diagram of an alternative embodiment of the transmitter including frequency modulation. This embodiment corresponds to the transmitter according to Fig. 1. To remove however, distortions in shape in the FM modulated signal, particularly if the modulation index is low, a quasi-steady-state circuit 11 is added after the power amplifier 10 (it can be implemented as a resonant load impedance of the power amplifier). By the addition of the quasi-steady-state circuit 11, the FM or PM modulated signal can be defined in a distortionless manner.

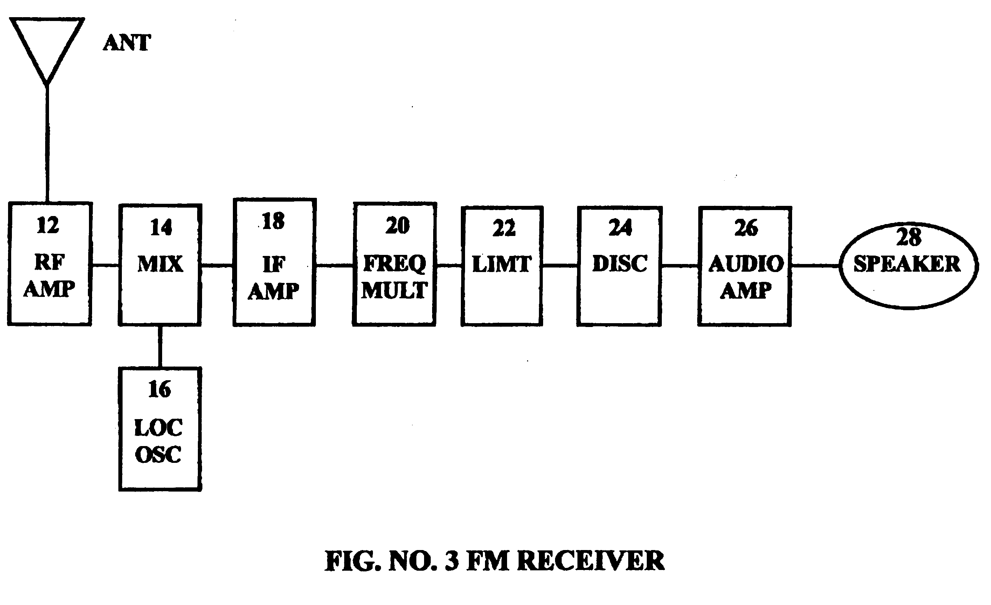

Fig. 3 shows a receiver for receiving the narrow band FM-signal as transmitted from the transmitter according to Fig. 1. The receiver conventionally includes a RF amplifier 12 at its input, a mixer 14 with a local oscillator 16 for down mixing the FM-signal into an IF-signal. The mixer 14 is succeeded by an IF amplifier 18. In accordance with the invention the receiver includes a frequency multiplier stage 20 connected to the IF amplifier 18 to generate locally an expanded frequency deviation which compensates for the small frequency band transmission as realized in the transmitter and the communication channel.

The frequency multiplier stage 20 is followed by a limiter 22 to eliminate all amplitude variation in the signal. The limiter 22 is followed by a discriminator 24 which converts the output of the limiter back to an audio signal which is finally applied to an audio amplifier 26 and to conventional audio equipment including a loud-speaker 28. When the frequency expanded signal is applied, the discriminator 24 shows improved discrimination properties with less distortion as compared with the processing of a non expanded signal.

The frequency multiplication in stage 20 can be realized by using for example the characteristic of non-linear circuit element and filtering out the non-wanted frequency ranges. For example a conventional limiter circuit may be used which generates a pulse signal from a sine signal. As the pulse signal includes all odd harmonics of the inputted sine function, for example the ninth harmonic may be filtered out, thus realizing a multiplication of the frequency by multiplication factor 9. Further, to realize an even higher multiplication factor, a plurality of these multipliers may be connected in cascade. To compensate for the loss in amplitude, additional amplification would be preferable.

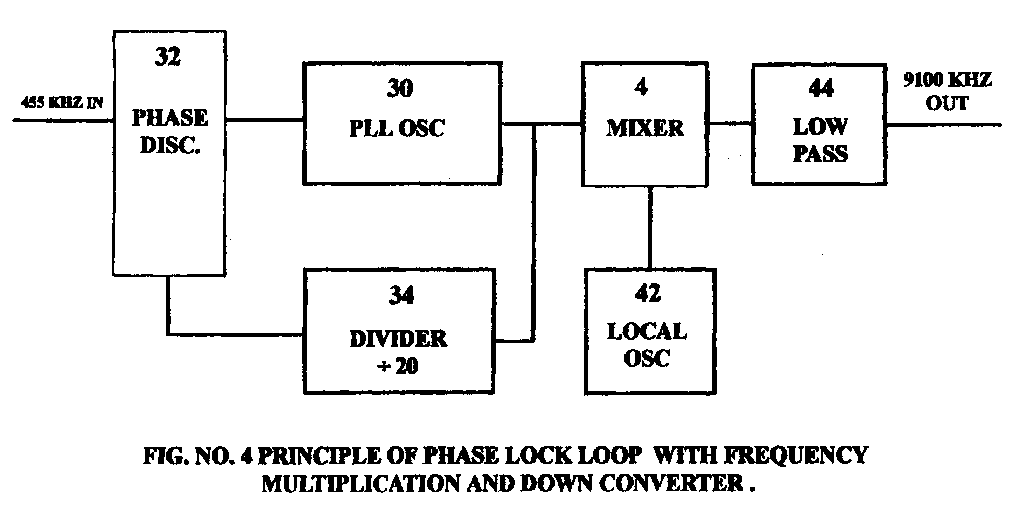

Fig. 4 shows the principle of a phase locked loop which may also be used for frequency multiplication. According to the circuit of Fig. 4, the oscillator 30 of the phase locked loop oscillates with the n-th harmonic of the input frequency, n being 1, 2, 3, ... The input signal is compared in a phase discriminator 32 with the oscillator signal which is divided by factor n in the divider 34 inserted in the closed loop of the phase locked loop amplifier. At the output of the phase locked loop amplifier 30 there is a mixer 40 with local oscillator 42, this mixer being followed by a low pass filter 44.

A theoretical reflection explaining how the word "multiplication" is to be understood is as follows:
It is common knowledge that a rectangular wave jumping periodically between a positiv and a negativ value can be described in the form$\text{Σ} \frac{\text{1}}{\text{2n - 1}} \text{cos (2n -1)} \frac{\text{2π · t}}{\text{T}} \text{, n = 1, 2, 3, ...}$ where T is the periode and t is the time variable.

On the other hand a frequency modulated signal s(t) has the form${\text{s(t) = cos (ω}}_{\text{c}} {\text{t + m cos ω}}_{\text{A}} \text{t)}$
ω_{c} = carrier frequency
ωₐ = audio frequency
m = $\frac{\text{ω}}{{\text{ω}}_{\text{A}}}$ = mod. index

Any harmonic selected out of a rectangularly limited frequency modulated signal is, therefor,${\text{cos[(2n-1)ω}}_{\text{c}} {\text{t + (2n-1)m cos ω}}_{\text{A}} \text{t].}$ Which shows that the modulation index has become${\text{M = (2}}_{\text{n}} \text{-1)m.}$

As m was defined as m = $\frac{\text{ω}}{{\text{ω}}_{\text{A}}}$ , with ω = the "original" frequency deviation and ω_{A} the audio it is apparent that the "new" frequency deviation is now (2n-1)ω.

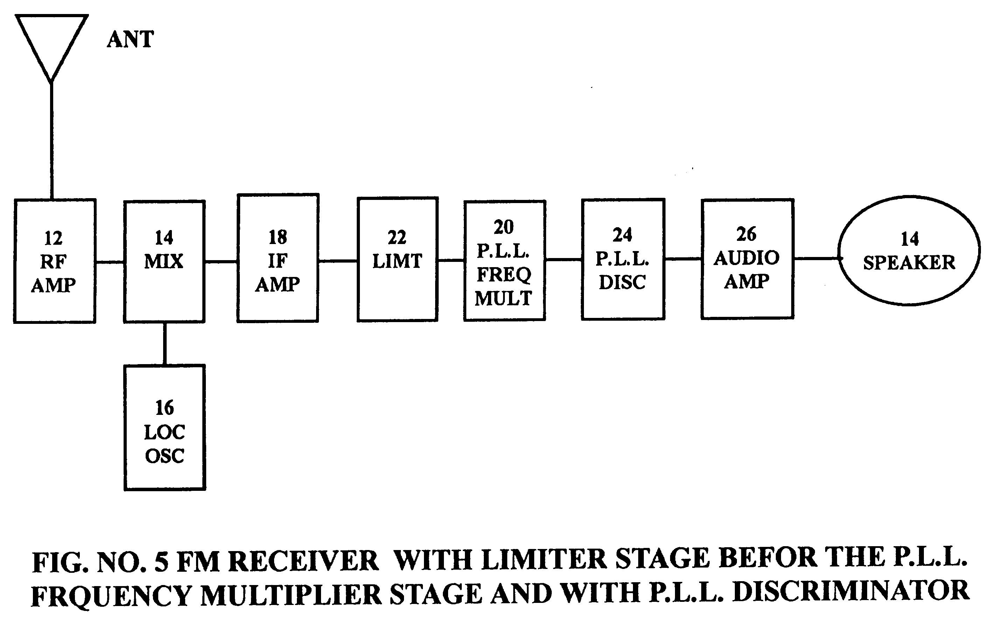

Fig. 5 shows a FM receiver using phased locked loop as a frequency multiplier. Because the P.L.L. is sensitive to noise, the IF-stage 18 is succeeded by a limiter stage 22 to remove the noise and any amplitude variation from the signal, then the signal pass through P.L.L. frequency multiplier stage 20, then to a P.L.L. discriminator stage 20 and after that to the audio amplifier stage 26 then to the speaker 14.

### SUMMARY

A narrow band FM or PM signal transmission can be implemented by transmitting a signal of small frequency band, said signal being expanded at the receiver side by expanding the frequency band of the FM or PM signal in the receiver, and converting the expanded signal down to a low frequency signal or audio signal.

## Claims

1. A method for transmitting frequency modulated or phase modulated wide-band information via a communication channel; characterized by:
connecting a transmitting side and a receiving side, involving frequency of phase modulation by compressing the band width by limiting the modulation index to 1 to reduce the frequency deviation which reduces the numbers of the side bands at the transmitting side of the communication channel and in the communication channel, the method comprising:
transmitting the compressed frequency or phase modulated signal via the communication channel to limit the frequency deviation and the side bands in the communication channel;
receiving the signal from the communication channel at a receiving side of communication channel; and
to compensate compressed frequency deviation in the transmitter by decompression the transmitted frequency or phase modulated frequency in the receiver by multiplying the I.F. signal to reach a modulation index of 9 or higher, depending on the multiplication factor of the I.F. signal.

2. The method can be used in analogue or digital signals in all frequency bands including the low frequency, medium frequency and high frequency bands.

3. The method of claim 1, further comprising:
converting the expanded wide-band I.F. frequency modulated signal to a low frequency signal or audio signal.

4. The method of claim 1, further comprising:
further processing the expanded-frequency of phase modulated signal.

5. The method of claim 1, further comprising:
converting the signal received from the communication channel to an intermediate frequency (IF) signal before expanding its frequency deviation.

6. The method of claim 1, wherein the expanding step includes:
expanding the frequency deviation of the received frequency modulated I.F. signal by frequency multiplication.

7. The method of claim 1, wherein the expanding step includes:
expanding the frequency deviation of received I.F. signal by a phase lock loop (PLL) frequency multiplier.

8. The method of claim 1, wherein:
a modulation index M, by which the transmitted signal is modulated, is 1 or less.

9. Receiving the frequency or phase modulated signal which have a limited predetermined frequency or phase deviation and which have been transmitted over a communication channel the receiver comprising:
means for receiving from the communication channel the signal that have the limited predetermined frequency deviation; and a circuit which expands the limited predetermined frequency deviation.

10. The receiver of claim 9, wherein the frequency deviation expanding circuit includes:
a circuit having non-linear characteristics; and a filter, connected to an output of the circuit having non-linear characteristics, the filter passing a multiplied frequency signal component.

11. The receiver according to claim 9, wherein the frequency deviation expanding circuit includes:
a phase lock loop circuit including a frequency divider having a dividing ratio which corresponds to a selected expansion for the frequency deviation.

12. The receiver of claim 11, wherein:
an output signal of the phase lock loop circuit is down converted to a wide-band intermediate frequency signal.

13. The receiver of claim 9, further comprising:
an amplitude limiter which eliminates amplitude variation of the frequency-deviation-expanded signal; and a discriminator for converting the signal out by the amplitude limiter into a low frequency or audio signal.

## Patentansprüche

1. Verfahren zum Übertragen von frequenzmodulierter oder phasenmodulierter Breitbandinformation über einen Kommunikationskanal;
gekennzeichnet durch:
Verbinden einer Übertragungsseite und einer Empfangsseite, Frequenz- oder Phasenmodulation durch Komprimieren der Bandbreite durch Begrenzen des Modulationsindex auf 1 beinhaltend, um die Frequenzabweichung zu reduzieren, welche die Anzahl der Seitenbänder auf der Übertragungsseite des Kommunikationskanals und in dem Kommunikationskanal reduziert, wobei das Verfahren aufweist:
das komprimierte frequenz- oder phasenmodulierte Signal wird über den Kommunikationskanal übertragen, um die Frequenzabweichung und die Seitenbänder in dem Kommunikationskanal zu begrenzen;
das Signal des Kommunikationskanals wird an einer Empfangsseite des Kommunikationskanals empfangen; und
komprimierte Frequenzabweichung in dem Transmitter wird durch Dekompression der übertragenen frequenz- oder phasenmodulierten Frequenz in dem Empfänger kompensiert, durch Multiplizieren des I.F. Signals, um einen Modulationsindex von 9 oder darüber zu erreichen, abhängig von dem Multiplikationsfaktor des I.F. Signals.

2. Das Verfahren kann bei analogen oder digitalen Signalen in allen Frequenzbändern einschließlich der Niederfrequenz-, Mittelfrequenz- und Hochfrequenzbänder verwendet werden.

3. Verfahren nach Anspruch 1, weiterhin aufweisend:
das erweiterte frequenzmodulierte I.F.-Breitbandsignal wird in ein Niederfrequenz- oder Audiosignal umgewandelt.

4. Verfahren nach Anspruch 1, weiterhin aufweisend:
das erweiterte frequenz- oder phasenmodulierte Signal wird weiter verarbeitet.

5. Verfahren nach Anspruch 1, weiterhin aufweisend:
das von dem Kommunikationssignal empfangene Signal wird in ein Zwischenfrequenz-(IF)-Signal vor dem Erweitern seiner Frequenzabweichung umgewandelt.

6. Verfahren nach Anspruch 1, wobei der Erweiterungsschritt einschließt:
die Frequenzabweichung des empfangenen frequenzmodulierten I.F.-Signals wird durch Frequenzmultiplikation erweitert.

7. Verfahren nach Anspruch 1, wobei der Erweiterungsschritt einschließt:
die Frequenzabweichung des empfangenen I.F.-Signals wird durch einen Phase Lock Loop (PLL)-Frequenzmultiplizierer erweitert.

8. Verfahren nach Anspruch 1, wobei ein Modulationsindex M, durch welchen das übertragenen Signal moduliert wird, 1 oder weniger ist.

9. Empfangen des frequenz- oder phasenmodulierten Signals, welche eine begrenzte vorbestimmte Frequenz- oder Phasenabweichung aufweist, und welches über einen Kommunikationssignal dem Empfänger übertragen wurde, wobei das Empfangen beinhaltet:
Mittel zum Empfangen des Signals von dem Kommunikationskanal, die die begrenzte vorbestimmte Frequenzabweichung aufweisen; und
eine Schaltung, welche die begrenzte, vorbestimmte Frequenzabweichung erweitert.

10. Empfänger nach Anspruch 9,
wobei die Frequenzabweichungserweiterungsschaltung einschließt: eine Schaltung mit nicht-linearen Eigenschaften; und einen Filter, welcher mit einem Ausgang der Schaltung mit nicht-linearen Eigenschaften verbunden ist, wobei der Filter eine multiplizierte Frequenzsignalkomponente hindurchläßt.

11. Empfänger nach Anspruch 9,
wobei die Frequenzabweichungserweiterungsschaltung einschließt:
eine Phase Lock Loop-Schaltung, einschließlich eines Frequenzteilers mit einem Teilungsverhältnis, welches einer ausgewählten Ausdehnung der Frequenzabweichung entspricht.

12. Empfänger nach Anspruch 11,
wobei ein Ausgangssignal der Phase Lock Loop-Schaltung nach unten auf ein Breitband-Zwischenfrequenzsignal umgewandelt wird.

13. Empfänger nach Anspruch 9, weiterhin enthaltend:
einen Amplitudenbegrenzer, welcher Amplitudenvariation des frequenzabweichungserweiterten Signals eliminiert; und einen Diskriminator zum Umwandeln des Signals, welches aus den Amplitudenbegrenzer tritt, in ein Niederfrequenz- oder Audiosignal.

## Revendications

1. Procédé pour transmettre des informations de large bande modulées en fréquence ou modulées en phase via un canal de communication ; caractérisé par :
la connexion d'un côté de transmission et d'un côté de réception, comprenant la modulation de fréquence ou de phase en compressant la largeur de bande en limitant l'indice de modulation à 1 afin de réduire la déviation de fréquence, ce qui réduit les nombres des bandes latérales du côté de transmission du canal de communication et dans le canal de communication, le procédé comprenant :
la transmission du signal modulé en fréquence ou en phase compressé via le canal de communication pour limiter la déviation de fréquence et les bandes latérales dans le canal de communication ;
la réception du signal provenant du canal de communication d'un côté de réception du canal de communication ; et
la compensation de la déviation de fréquence compressée dans l'émetteur par la décompression de la fréquence modulée en fréquence ou en phase transmise dans le récepteur en multipliant le signal de fréquence intermédiaire pour atteindre un indice de modulation de 9 ou supérieur, en fonction du facteur de multiplication du signal de fréquence intermédiaire.

2. Procédé pouvant être utilisé dans des signaux analogiques ou numériques dans toutes les bandes de fréquences, comprenant les bandes de basse fréquence, de moyenne fréquence et de haute fréquence.

3. Procédé selon la revendication 1, comprenant, de plus :
la conversion du signal décompressé modulé en fréquence de fréquence intermédiaire de large bande en un signal de basse fréquence ou en un signal audio.

4. Procédé selon la revendication 1, comprenant, de plus :
le traitement supplémentaire du signal modulé en phase dont la fréquence a été décompressée.

5. Procédé selon la revendication 1, comprenant, de plus :
la conversion du signal reçu en provenance du canal de communication en un signal de fréquence intermédiaire avant de décompresser sa déviation de fréquence.

6. Procédé selon la revendication 1, dans lequel l'étape de décompression comprend :
la décompression de la déviation de fréquence du signal de fréquence intermédiaire modulé en fréquence reçu par multiplication de fréquence.

7. Procédé selon la revendication 1, dans lequel l'étape de décompression comprend :
la décompression de la déviation de fréquence du signal de fréquence intermédiaire reçu par un multiplicateur de fréquence à boucle à verrouillage de phase.

8. Procédé selon la revendication 1, dans lequel :
un indice de modulation M, par lequel le signal transmis est modulé, est de 1 ou inférieur.

9. Récepteur pour recevoir le signal modulé en fréquence ou en phase qui a une déviation de fréquence ou de phase prédéterminée limitée et qui a été transmis sur un canal de communication, le récepteur comprenant :
des moyens pour recevoir, en provenance du canal de communication, le signal qui a la déviation de fréquence prédéterminée limitée ; et un circuit qui décompresse la déviation de fréquence prédéterminée limitée.

10. Récepteur selon la revendication 9, dans lequel le circuit de décompression de déviation de fréquence comprend :
un circuit présentant des caractéristiques non linéaires ; et un filtre. connecté à une sortie du circuit présentant des caractéristiques non linéaires. le filtre laissant passer une composante de signal de fréquence multipliée.

11. Récepteur selon la revendication 9, dans lequel le circuit de décompression de déviation de fréquence comprend :
un circuit à verrouillage de phase comprenant un diviseur de fréquence ayant un rapport de division qui correspond à une décompression sélectionnée pour la déviation de fréquence.

12. Récepteur selon la revendication 11, dans lequel :
un signal de sortie du circuit de boucle à verrouillage de phase est converti en un signal de fréquence intermédiaire à large bande.

13. Récepteur selon la revendication 9, comprenant, de plus :
un limiteur d'amplitude qui élimine la variation d'amplitude du signal dont la déviation de fréquence a été décompressée ; et un discriminateur pour convertir le signal par le limiteur d'amplitude en un signal de basse fréquence ou audio.
